# EUROPÄISCHE PATENTSCHRIFT

(11) **EP 2 359 671 B1**
(45) Veröffentlichungstag und Bekanntmachung des Hinweises auf die Patenterteilung: **02.01.2013**
(21) Anmeldenummer: 09804251.8
(22) Anmeldetag: 10.12.2009
(51) Int. Cl.: H05K 9/00, H01Q 17/00

(54) **STECKERVERBINDUNGEN AN RADARSENSOREN UND VERFAHREN ZU DEREN HERSTELLUNG**
PLUG CONNECTIONS ON RADAR SENSORS AND METHOD OF PRODUCING SAME
CONNEXIONS ENFICHABLES POUR CAPTEURS RADAR ET PROCÉDÉ POUR LEUR FABRICATION

(30) Priorität: 13.12.2008 DE 102008062190
(43) Veröffentlichungstag der Anmeldung: 24.08.2011
(73) Patentinhaber: Valeo Schalter und Sensoren GmbH, 74321 Bietigheim-Bissingen (DE)
(72) Erfinder: HABERLAND, Udo, 71088 Holzgerlingen (DE); LUEBBERT, Urs, 74321 Bietigheim-Bissingen (DE); PFITZENMAIER, Patrick, 74354 Besigheim (DE)
(86) Internationale Anmeldenummer: PCT/EP2009/008850
(87) Internationale Veröffentlichungsnummer: WO 2010/066434

(56) Entgegenhaltungen:
- EP-A2- 1 469 552
- DE-C2- 3 311 001
- GB-A- 2 181 898
- US-A- 3 599 210

## Beschreibung

### Stand der Technik

Die Erfindung betrifft Steckerverbindungen an Radarsensoren und Verfahren zu deren Herstellung nach der Gattung des Haupt- und des Verfahrensanspruchs.

Es ist an sich üblich, dass bei Steckerverbindungen die Steckerpins eines Steckerteils zunächst in ein isolierendes Material, vorzugsweise Kunststoff, eingebettet werden und dann als sogenanntes Insert in eine kundenspezifische Steckerverbindung eingefügt werden. Ein solches Insert kann zum Beispiel als Einlegeteil in ein Werkzeug gelegt werden und dann in ein entsprechendes Gehäuse eingespritzt werden. Meist bestehen dabei das vorumspritzte Insert und das Gehäuse aus dem gleichem Material.

Für sich gesehen ist weiterhin bekannt, dass bei einer Verwendung von Kunststoff im Bereich von Radarsensoren für eine Entkopplung des Radarsensors vom Nahbereich bzw. vom Umfeld ein im Frequenzbereich der Radarwellen (z.B. bei 24GHz) absorbierender Kunststoff eingesetzt wird. Aus der EP 1 471 598 A1 ist zum Beispiel bekannt, dass zur Abdeckung solcher Radarsensoren ein schwammartiger Kunststoff verwendet wird, dem ein radarwellenabsorbierendes Granulat beigemischt ist. Ein solcher spezieller Kunststoff minimiert den Einfluss von Störungen, welche durch bspw. metallische Teile in der Nähe des Radarsensors hervorgerufen werden. Dieser somit bekannte hochfrequente Wellen absorbierende Kunststoff wird in der Regel jedoch nur im Bereich von Radarsensoren als Halter oder sonst wie zur Abschirmung eingesetzt.

### Darstellung der Erfindung

Die Erfindung geht von Steckerverbindungen an Radarsensoren mit in Kunststoff eingefügten Steckerpins aus, bei denen erfindungsgemäß in vorteilhafter Weise der die Steckerpins umgebende Kunststoff zumindest teilweise mit einem radarwellenabsorbierenden Granulat derart versehen ist, dass der elektrische Widerstand des Kunststoffs zwischen den Steckerpins im niederfrequenten Bereich einen hohen Wert aufweist und der Kunststoff im Bereich der höherfrequenten Radarwellen eine radarwellenabsorbierende Eigenschaft aufweist.

Die Steckerpins sind dabei erfindungsgemäß in vorteithafter Weise mit einer dünnen Schicht Kunststoff ohne radarabsorbierendes Granulat direkt umgeben und die weitere Umgebung der Steckerpins besteht aus dem Kunststoff mit dem radarwellenabsorbierenden Granulat. Ein solcher radarwellenabsorbierender Kunststoff, der vorzugsweise mit Graphitbestandteilen versehen ist, kann zum Beispiel in einer an sich bekannten Ausführungsform eine elektrische Leitfähigkeit von ca. 10 kΩ/cm aufweisen. Der Abstand der Steckerpins kann beispielsweise ca. 1,9 mm bei einem Raster von 2,54 mm aufweisen, woraus sich hier ein elektrischer Widerstandswert zwischen zwei Steckerpins von ca. 2,5kΩ ergibt. Mit der Erfindung ist nun erreicht, dass die Steckerpins nicht mit dem radarabsorbierenden Kunststoff in Verbindung kommen und der elektrische Widerstand zwischen den Steckerpins durch die zusätzliche Isolationsschicht dadurch stark erhöht worden ist. Der Kunststoff für die zusätzliche Isolationsschicht kann als Basismaterial dem des radarabsorbierenden Materials gleichen, jedoch ohne die leitfähige Zusätze, wie zum Beispiel Graphit.

Es ist auch vorteilhaft, um ein einfaches und kostengünstiges Herstellungsverfahren zu ermöglichen, in einem Insert die Steckerpins großflächig in ein elektrisch isolierendes Kunststoffbett einzufügen und um dieses Kunststoffbett den Kunststoff mit dem radarwellenabsorbierenden Granulat zu spritzen.

Mit einem erfindungemäßen Verfahren zur Herstellung von Steckerverbindungen der zuvor beschriebenen Art kann auf einfache Weise ein Radarsensor elektrisch kontaktiert werden und es können die Steckerpins in ein Gehäuse eingespritzt werden. In einem ersten Verfahrensschritt werden zum Beispiel die Steckerpins mit dem elektrisch nicht oder schlecht leitendem Kunststoff umspritzt und in einem zweiten Verfahrensschritt wird eine Umspritzung der so vorbehandelten Steckerpins mit dem radarwellenabsorbierenden Kunststoff vorgenommen.

Beispielsweise können die Steckerpins auch zur Bildung eines Inserts zusammengefügt und im ersten Verfahrensschritt (Vorumspritzung) mit dem elektrisch nicht oder schlecht leitendem Kunststoff umspritzt werden und dann kann das Insert in ein Werkzeug zur Herstellung eines Gehäuses eingelegt werden, in dem es mit dem radarwellenabsorbierenden Kunststoff einge- oder umspritzt wird.

Alternativ dazu können die Steckerpins auch gleich in ein Werkzeug zur Herstellung eines Gehäuses eingelegt werden und im Zuge eines ZweiKomponenten-Verfahrens im ersten Verfahrensschritt mit dem elektrisch nicht oder schlecht leitendem Kunststoff umspritzt werden und dann wird der Rest des Gehäuses mit dem radarwellenabsorbierenden Kunststoff gespritzt oder gefüllt. Es ist auch möglich, dass die Steckerpins vor dem Einbringen in ein Insert oder in ein Werkzeug zur Herstellung eines Gehäuses schon elektrisch isolierend beschichtet sind.

Gemäß einer vorteilhaften Verwendung der erfindungsgemäßen Steckerverbindungen nach Anspruch 10 können die Steckerverbindungen in einem Gehäuse für einen Radarsensor für ein Umfelderkennungssystem an einem Kraftfahrzeug angebracht werden.

### Kurze Beschreibung der Zeichnung

Ein Ausführungsbeispiel der Erfindung wird anhand der Figuren der Zeichnung erläutert. Es zeigen:
Figur 1 eine Ansicht auf ein Gehäuse eines Radarsensors mit elektrischen Steckerverbindungen,
Figur 2 eine Detailansicht auf ein Insert mit den Steckerpins der Steckerverbindungen nach der Figur 1 mit einer elektrisch isolierenden und einer radarwellenabsorbierenden Kunststoffschicht und
Figur 3 eine Detailansicht auf ein Insert mit den Steckerpins der Steckerverbindungen nach der Figur 1 mit einer anderen Ausführungsform einer elektrisch isolierenden und einer radarwellenabsorbierenden Kunststoffschicht.

### Weg zur Ausführung der Erfindung

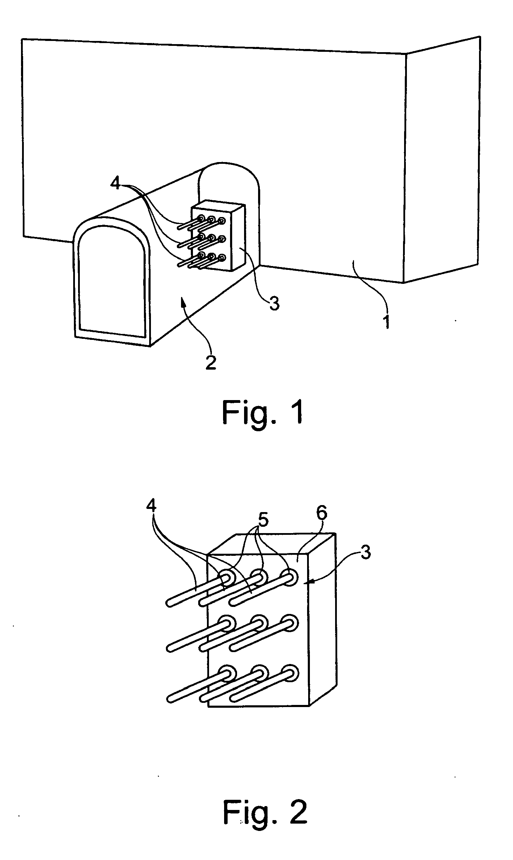

In Figur 1 ist in ein Gehäuse 1 für einen Radarsensor gezeigt, wie er beispielsweise in der Automobiltechnik zum Anbau in den Stoßfänger eines Fahrzeugs für ein Umfelderkennungssystem eingesetzt wird. Am Gehäuse 1 sind Steckerverbindungen 2 angebracht, über die eine hier nicht weiter gezeigte elektrische Kontaktierung der elektrischen Bauteile des Radarsensors an ein weiterführendes Leitungs- oder Bussystem im Fahrzeug möglich ist.

Die Steckerverbindungen 2 sind hier mit einem Insert 3 als vorumspritztes Kunststoffbauteil versehen, das eine vorgegebene Anzahl von Steckerpins 4 trägt.

Aus Figur 2 ist nun im Detail zu entnehmen, wie die Steckerpins 4 im Insert 3 mit einer dünnen Schicht aus einem Kunststoff 5 ohne radarabsorbierendes Granulat umgeben ist und die weitere Umgebung der Steckerpins, also die Masse des Inserts 3 aus einem Kunststoff 6 mit dem radarwellenabsorbierenden Granulat, vorzugsweise Graphit, besteht. Die Steckerpins 4 kommen daher nicht mit dem radarabsorbierenden Kunststoff 6 in Verbindung, sodass der elektrische Widerstand zwischen den Steckerpins 4 dadurch stark erhöht worden ist und gleichzeitig die radarabsorbierenden Eigenschaften des Gehäuses 1 auch im Bereich der Steckerverbindungen 2 erhalten worden sind.

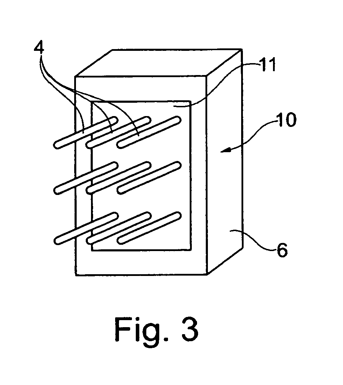

In Figur 3 ist ein Ausführungsbeispiel gezeigt, bei dem ein Insert 10 so ausgeführt ist, dass die Steckerpins 4 großflächiger in ein elektrisch isolierendes Kunststoffbett 11 eingefügt sind. Um dieses Kunststoffbett 11 ist dann der Kunststoff 6 mit dem radarwellenabsorbierenden Granulat gespritzt.

## Patentansprüche

1. Steckerverbindungen an Radarsensoren mit in Kunststoff eingefügten Steckerpins, **dadurch gekennzeichnet, dass** der die Steckerpins (4) umgebende Kunststoff (5,6;11) zumindest teilweise mit einem radarwellenabsorbierenden Granulat derart versehen ist, dass der elektrische Widerstand des Kunststoffs (5;11) im niederfrequenten Bereich einen hohen Wert aufweist und der Kunststoff (6) im Bereich der höherfrequenten Radarwellen eine radarwellenabsorbierende Eigenschaft aufweist, wobei die Steckerpins (4) mit einer dünnen Schicht Kunststoff (5) ohne radarabsorbierendes Granulat direkt umgeben sind und die weitere Umgebung der Steckerpins aus dem Kunststoff (6) mit dem radarwellenabsorbierenden Granulat besteht, so dass die Steckerpins (4) nicht damit in Verbindung kommen.

2. Steckerverbindungen nach Anspruch 1, **dadurch gekennzeichnet, dass** die weitere Umgebung der Steckerpins in einem Insert (3) aus dem Kunststoff (6) mit dem radarwellenabsorbierenden Granulat besteht.

3. Steckerverbindungen nach Anspruch 2, **dadurch gekennzeichnet, dass** die dünne Schicht einen Bruchteil des Abstandes der Steckerpins (4) untereinander ausmacht.

4. Steckerverbindungen nach Anspruch 1, **dadurch gekennzeichnet, dass** ein Insert (10) so ausgeführt ist, dass die Steckerpins (4) großflächig in ein elektrisch isolierendes Kunststoffbett (11) eingefügt sind und dass um dieses Kunststoffbett (11) der Kunststoff (6) mit dem radarwellenabsorbierenden Granulat gespritzt ist.

5. Steckerverbindungen nach einem der Ansprüche 1 bis 4, **dadurch gekennzeichnet, dass** der radarwellenabsorbierende Kunststoff (6) mit einem Granulat aus Graphitbestandteilen versehen ist.

6. Verfahren zur Herstellung von Steckerverbindungen nach einem der vorhergehenden Ansprüche, **dadurch gekennzeichnet, dass** in einem ersten Verfahrensschritt die Steckerpins (4) mit einem elektrisch nicht oder schlecht leitendem Kunststoff (5;11) umspritzt werden und in einem zweiten Verfahrensschritt eine Umspritzung der so vorbehandelten Steckerpins (4) mit einem radarwellenabsorbierenden Kunststoff (6) vorgenommen wird.

7. Verfahren zur Herstellung von Steckerverbindungen nach Anspruch 6, **dadurch gekennzeichnet, dass** die Steckerpins (4) zur Bildung eines Inserts (3) zusammengefügt und im ersten Verfahrensschritt mit dem elektrisch nicht oder schlecht leitendem Kunststoff (5;11) umspritzt werden und dann das Insert (3) in ein Werkzeug zur Herstellung eines Gehäuses (1) eingelegt wird, in dem es mit dem radarwellenabsorbierenden Kunststoff (6) einge- oder umspritzt wird.

8. Verfahren zur Herstellung von Steckerverbindungen nach Anspruch 6, **dadurch gekennzeichnet, dass** die Steckerpins (4) in ein Werkzeug zur Herstellung eines Gehäuses (1) eingelegt werden und im ersten Verfahrensschritt mit dem elektrisch nicht oder schlecht leitendem Kunststoff (5;11) umspritzt werden und dann der Rest des Gehäuses (1) mit dem radarwellenabsorbierenden Kunststoff (6) gespritzt oder gefüllt wird.

9. Verfahren zur Herstellung von Steckerverbindungen nach einem der Ansprüche 6 bis 8, **dadurch gekennzeichnet, dass** die Steckerpins (4) vor dem Einbringen in ein Insert (3) oder in ein Werkzeug zur Herstellung eines Gehäuses (1) elektrisch isolierend beschichtet sind.

10. Verwendung der Steckerverbindungen nach einem der vorhergehenden Ansprüche 1 bis 5, **dadurch gekennzeichnet, dass** die Steckerverbindungen (2) in einem Gehäuse (1) für einen Radarsensor für ein Umfelderkennungssystem an einem Kraftfahrzeug angebracht sind.

## Claims

1. Plug connections on radar sensors having plug pins which are inserted into plastic, **characterized in that** the plastic (5, 6; 11) which surrounds the plug pins (4) is at least partially provided with a granulate which absorbs radar waves, such that the electrical impedance of the plastic (5; 11) has a high value in the low-frequency range, and the plastic (6) has a characteristic which absorbs radar waves in the region of higher-frequency radar waves, wherein the plug pins (4) are directly surrounded by a thin layer of plastic (5) without radar-absorbent granulate, and the rest of the area surrounding the plug pins consists of the plastic (6) with the granulate which absorbs radar waves, so that the plug pins (4) do not come into contact therewith.

2. Plug connections according to Claim 1, **characterized in that** the rest of the area surrounding the plug pins in an insert (3) consists of the plastic (6) with the granulate which absorbs radar waves.

3. Plug connections according to Claim 2, **characterized in that** the thin layer makes up a fraction of the distance between the plug pins (4).

4. Plug connections according to Claim 1, **characterized in that** an insert (10) is designed such that the plug pins (4) are inserted over a large area into an electrically insulating plastic bed (11), and such that the plastic (6) around this plastic bed (11) is sprayed with the granulate which absorbs radar waves.

5. Plug connections according to one of Claims 1 to 4, **characterized in that** the plastic (6) which absorbs radar waves is provided with a granulate composed of graphite components.

6. Method for production of plug connections according to one of the preceding claims, **characterized in that**, in a first method step, the plug pins (4) are insert-moulded with a plastic (5; 11) which is electrically non-conductive or poorly conductive and, in a second method step, the plug pins (4) which have been pretreated in this way are insert-moulded with a plastic (6) which absorbs radar waves.

7. Method for production of plug connections according to Claims 6, **characterized in that** the plug pins (4) are joined together to form an insert (3) and, in the first method step, are insert-moulded with the electrically non-conductive or poorly conductive plastic (5; 11), and the insert (3) is then inserted into a mould for production of a housing (1), in which it is injection-moulded or insert-moulded with the plastic (6) which absorbs radar waves.

8. Method for production of plug connections according to Claim 6, **characterized in that** the plug pins (4) are inserted into a mould for production of a housing (1) and, in the first method step, are insert-moulded with an electrically non-conductive or poorly conductive plastic (5; 11), and the rest of the housing (1) is then sprayed or filled with the plastic (6) which absorbs radar waves.

9. Method for production of plug connections according to one of Claims 6 to 8, **characterized in that** the plug pins (4) are coated in an electrically insulating manner before being introduced into an insert (3) or into a mould for production of a housing (1).

10. Use of the plug connections according to one of the preceding Claims 1 to 5, **characterized in that** the plug connections (2) are fitted to a motor vehicle, in a housing (1) for a radar sensor for a surrounding-area identification system.

## Revendications

1. Connexions mâles sur des capteurs radar comprenant des broches mâles introduites dans une matière plastique, **caractérisées en ce que** la matière plastique (5, 6 ; 11) qui entoure les broches mâles (4) est munie au moins partiellement d'un granulat qui absorbe les ondes radar de telle sorte que la résistance électrique de la matière plastique (5 ; 11) présente une valeur élevée dans la plage des basses fréquences et la matière plastique (6) présente dans la plage des ondes radar à fréquences plus élevées une propriété d'absorption des ondes radar, les broches mâles (4) étant entourées directement d'une mince couche de matière plastique (5) sans granulat qui absorbe les ondes radar et le reste de l'entourage des broches mâles se composant de la matière plastique (6) dotée du granulat qui absorbe les ondes radar, de sorte que les broches mâles (4) n'entrent pas en contact avec celle-ci.

2. Connexions mâles selon la revendication 1, **caractérisées en ce que** le reste de l'entourage des broches mâles est constitué d'un insert (3) en la matière plastique (6) dotée du granulat qui absorbe les ondes radar.

3. Connexions mâles selon la revendication 2, **caractérisées en ce que** la couche mince représente une fraction de l'écart des broches mâles (4) entre elles.

4. Connexions mâles selon la revendications 1, **caractérisées en ce qu'**un insert (10) est réalisé de telle sorte que les broches mâles (4) sont introduites sur une grande surface dans un lit en matière plastique (11) électriquement isolant et **en ce que** la matière plastique (6) dotée du granulant qui absorbe les ondes radar est moulée par injection autour de ce lit en matière plastique (11).

5. Connexions mâles selon l'une des revendications 1 à 4, **caractérisées en ce que** la matière plastique (6) absorbant les ondes radar est dotée d'un granulat en composantes de graphite.

6. Procédé de fabrication de connexions mâles selon l'une des revendications précédentes, **caractérisé en ce que** dans une première étape du procédé, les broches mâles (4) sont surmoulées par injection avec une matière plastique (5 ; 11) électriquement non ou mauvaise conductrice et, dans une deuxième étape du procédé, est effectué un surmoulage par injection des broches mâles (4) ainsi préparées avec une matière plastique (6) absorbant les ondes radar.

7. Procédé de fabrication de connexions mâles selon la revendication 6, **caractérisé en ce que** les broches mâles (4) sont assemblées pour former un insert (3) et sont surmoulées par injection avec la matière plastique (5 ; 11) électriquement non ou mauvaise conductrice au cours de la première étape du procédé et l'insert (3) est ensuite déposé dans un outil de fabrication d'un boîtier (1) dans lequel il est enrobé ou surmoulé par injection avec la matière plastique (6) absorbant les ondes radar.

8. Procédé de fabrication de connexions mâles selon la revendication 6, **caractérisé en ce que** les broches mâles (4) sont déposées dans un outil de fabrication d'un boîtier (1) et sont surmoulées par injection avec la matière plastique (5 ; 11) électriquement non ou mauvaise conductrice au cours de la première étape du procédé et le reste du boîtier (1) est ensuite moulé par injection ou rempli avec la matière plastique (6) absorbant les ondes radar.

9. Procédé de fabrication de connexions mâles selon l'une des revendications 6 à 8, **caractérisé en ce que** les broches mâles (4) reçoivent un enduit électriquement isolant avant leur introduction dans un insert (3) ou avant de les déposer dans un outil de fabrication d'un boîtier (1).

10. Utilisation de connexions mâles selon l'une des revendications précédentes 1 à 5, **caractérisée en ce que** les connexions mâles (2) sont montées dans un boîtier (1) pour un capteur radar pour un système de détection d'environnement sur un véhicule automobile.
